# FASCICULE DE BREVET EUROPEEN

(11) **EP 1 544 919 B1**
(45) Date de publication et mention de la délivrance du brevet: **09.06.2010**
(21) Numéro de dépôt: 04106574.9
(22) Date de dépôt: 14.12.2004
(51) Int. Cl.: H01L 29/747

(54) **Triac**
Triac
Triac

(30) Priorité: 19.12.2003 FR 0351138
(43) Date de publication de la demande: 22.06.2005
(73) Titulaire: ST MICROELECTRONICS S.A., 92120 Montrouge (FR)
(72) Inventeur: Memard, Samuel, 37000, Tours (FR)
(74) Mandataire: de Beaumont, Michel

(56) Documents cités:
- EP-A- 0 635 889
- WO-A-03/056631
- JP-A- 56 148 864
- US-A- 4 604 638
- US-A- 5 838 110

## Description

La présente invention concerne un triac susceptible de fonctionner dans les quadrants Q1 et Q4 et pouvant, dans ces quadrants, être déclenché par un faible courant de gâchette Igt, tout en étant peu sensible à un déclenchement parasite par un front de tension (déclenchement en dV/dt).

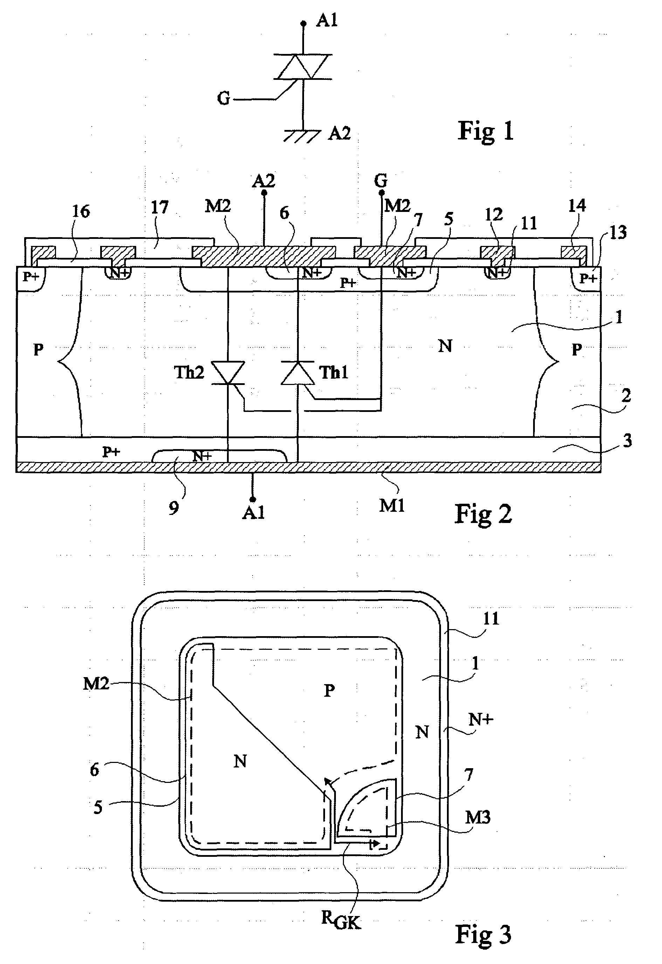

La figure 1 représente le schéma équivalent d'un triac qui comprend des bornes principales A1 et A2 et une borne de gâchette G référencée à la borne A2. Par analogie avec un thyristor, on a tendance à appeler la borne A1 anode et la borne A2 cathode, mais on notera que dans un triac la borne A1 est destinée à être connectée à une charge elle-même connectée à une alimentation alternative positive ou négative par rapport à la borne A2. En considérant que la borne A2 est reliée à la masse, on définit les quadrants de commande d'un triac de la façon suivante :
- premier quadrant (Q1): : A1 positif, G positif,
- deuxième quadrant (Q2): : A1 positif, G négatif,
- troisième quadrant (Q3): : A1 négatif, G négatif,
- quatrième quadrant (Q4): : A1 négatif, G positif.

Les figures 2 et 3 représentent respectivement une vue en coupe schématique et une vue de dessus schématique d'un exemple de triac classique. Ce triac est formé dans un substrat 1 faiblement dopé de type N entouré d'un mur d'isolement fortement dopé de type P. La face arrière de la structure comprend essentiellement une couche 3 de type P. Du côté de la face avant est formé un caisson 5 de type P dans lequel sont formées une région principale 6 de type N et une région auxiliaire 7 de type N. Du côté de la face arrière, dans la couche 3, est formée une région 9 de type N en regard du caisson de type P, principalement dans les régions non occupées par la région principale de type N 6. L'ensemble de la face arrière est revêtu d'une métallisation M1 destinée à être connectée à la borne principale A1 du triac. Du côté de la face avant, une métallisation principale M2, en contact avec le caisson 5 et la région 6, est destinée à être connectée à la borne A2 du triac, généralement reliée à la masse GND. Il existe ainsi un thyristor Th1 constitué des régions 3-1-5-6 qui peut être rendu passant dans les quadrants Q1 et Q2 et un thyristor Th2 constitué des régions 5-1-3-9 qui peut être rendu passant dans les quadrants Q3 et Q4. La région auxiliaire de type N 7 est revêtue d'une métallisation M3 destinée à être connectée à la borne de gâchette G.

On a en outre représenté en figure 2 un anneau d'arrêt de canal de type N⁺ sensiblement à mi-chemin entre la limite du caisson P 5 et le mur d'isolement 2. Cet anneau 11 est généralement revêtu d'une métallisation 12 non connectée à une borne extérieure. De même, la périphérie du composant comporte généralement un anneau 13, formé dans le mur d'isolement 2, fortement dopé de type P revêtu d'une métallisation 14 non connectée à une borne extérieure. Les parties de la surface supérieure du silicium non en contact avec une métallisation sont protégées par une couche isolante 16, généralement en oxyde de silicium, et l'ensemble de la face supérieure, sauf les parties de métallisations à contacter, est revêtue d'une couche isolante 17, par exemple un verre PSG.

Dans la vue de dessus de la figure 3, on a représenté la partie interne à l'anneau d'arrêt de canal 11. Entre l'extérieur du caisson P 5 et l'anneau 11 apparaît une partie du substrat 1. On a également représenté la limite de la région principale de type N 6 et la limite de la région auxiliaire de type N 7. On a représenté par des traits en pointillés, d'une part la zone dans laquelle la métallisation M2 est en contact avec le caisson 5 et la région 6, d'autre part la zone dans laquelle la métallisation M3 est en contact d'une part avec la région auxiliaire de gâchette, d'autre part avec une portion du caisson 7 (ce contact entre la métallisation M3 et une portion du caisson P 7 n'est pas visible dans la vue en coupe de la figure 2). On rappellera que l'amorçage d'un triac, qui ne sera pas décrit en détail ici, débute par la circulation d'un courant entre la gâchette et la cathode selon le trajet résistif désigné par R_{GK} en figure 3, ce qui provoque, après plusieurs étapes intermédiaires, la mise en conduction de celui des thyristors Th1 et Th2 qui est convenablement polarisé.

Il est connu que de tels triacs sont susceptibles d'être commandés relativement facilement dans les quadrants Q1, Q2 et Q3 mais fonctionnent mal ou pas dans le quadrant Q4. Ainsi, il n'est pas possible de commander la gâchette par un signal positif quelle que soit la polarité des bornes principales du triac. On en arrive donc à commander systématiquement les triacs dans les quadrants Q2 et Q3, c'est-à-dire avec une tension de gâchette négative par rapport à la masse, ce qui complexifie les circuits de commande.

Par ailleurs, du fait de la résistance intégrée R_{GK} entre gâchette et cathode, il est très difficile d'obtenir des structures à faible courant de commande gâchette-cathode ayant de plus de bonnes performances dynamiques notamment au niveau d'éventuels déclenchements parasites par des variations brutales de tension aux bornes (déclenchement en dV/dt). En effet, plus R_{GK} est faible, plus l'insensibilité à un déclenchement en dV/dt est élevée, par contre plus les courants de commande doivent être élevés. Ceci présente un inconvénient car on souhaiterait pouvoir piloter facilement des triacs par de faibles courants de manière à pouvoir, par exemple, les commander directement par un microcontrôleur. D'autre part, la tenue en dV/dt est un paramètre important pour éviter les déclenchements par des bruits parasites, notamment dans les applications automobiles.

Ainsi, un objet de la présente invention est de prévoir un triac sensible dans les quadrants Q1 et Q4, dans lequel le compromis entre le courant de commande de gâchette et la tenue en dV/dt puisse être optimisé.

Un autre objet de la présente invention est de prévoir un tel triac facile à réaliser par les technologies existantes.

Pour atteindre ces objets, la présente invention prévoit un triac selon la revendication 1.

Selon un mode de réalisation de la présente invention, le caisson auxiliaire est disposé au voisinage immédiat du caisson principal de face avant.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
la figure 1 représente le symbole usuel d'un triac ;
la figure 2 est une vue en coupe simplifiée d'un triac classique ;
la figure 3 est une vue de dessus simplifiée d'un triac classique ;
la figure 4 est une vue en coupe simplifiée d'un triac selon la présente invention ; et
la figure 5 est une vue de dessus simplifiée d'un triac selon la présente invention.

Comme cela est usuel dans le domaine de la représentation des composants semiconducteurs, les dimensions en coupe et de dessus ne sont pas à l'échelle mais ont été arbitrairement dilatées ou contractées pour faciliter le tracé et la lisibilité des figures.

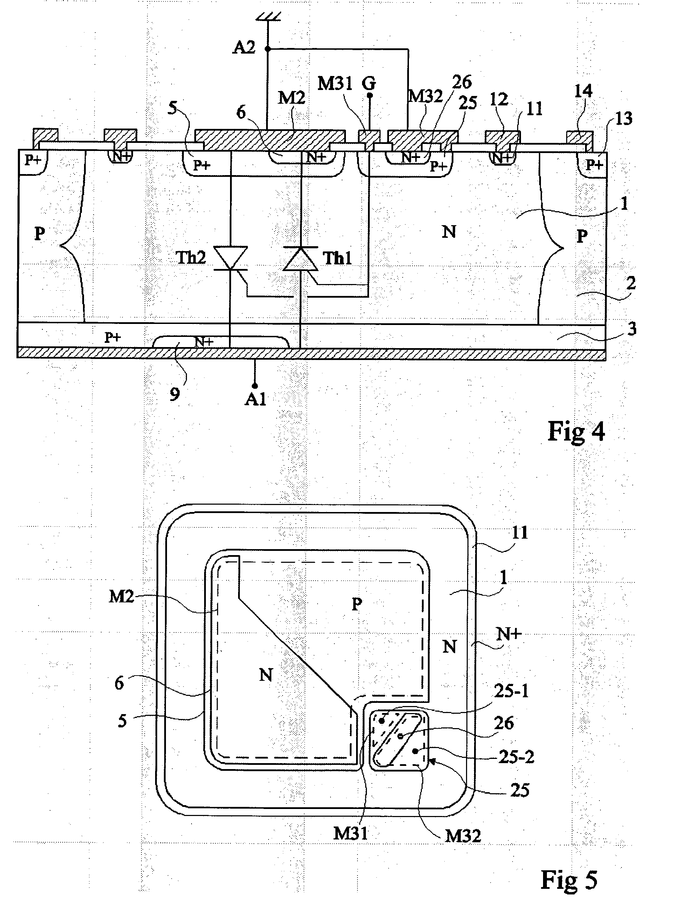

Les figures 4 et 5 représentent en vue en coupe et en vue de dessus, de façon simplifiée, un mode de réalisation d'un triac selon la présente invention. Dans ces vues, de mêmes références qu'en figures 2 et 3 sont utilisées pour désigner des éléments analogues qui ne seront pas décrits à nouveau. Notamment, on retrouve en figure 4 les thyristors Th1 (3-1-5-6) et Th2 (5-1-3-9), connectés entre les métallisations M1 et M2.

La différence principale entre l'invention et l'état de la technique décrit en relation avec les figures 2 et 3 réside dans la zone d'amorçage du triac. La présente invention prévoit un caisson auxiliaire de type P 25 distinct du caisson principal de type P 5 dans lequel est formée la région principale de type N 6. Dans ce caisson 25 est formée une région auxiliaire de type N 26 moins profonde que le caisson. Comme le montre mieux la vue de dessus de la figure 5, la région 26 s'étend dans le caisson 25 de façon à le partager en vue de dessus en une portion 25-1 et une portion 25-2 de part et d'autre de cette région 26.

La surface supérieure de la portion 25-1 du caisson 25 est revêtue d'une métallisation M31, et les surfaces supérieures de la région 26 et de la portion 25-2 du caisson 25 sont revêtues d'une métallisation M32. La métallisation M32 est connectée à la métallisation M2 reliée à la borne principale A2, couramment reliée à la masse. En pratique, bien que cela ne soit pas représenté, l'ensemble des métallisations M2 et M32 constituera une seule et même métallisation. La métallisation M31 est reliée à une borne de commande ou borne de gâchette G.

Quand une tension positive est appliquée sur la borne G par rapport à la borne A2, un courant circule de la borne G à la borne A2. Ce courant circule dans le semiconducteur de type P constituant le caisson P 25 depuis la portion 25-1, sous la région 26 vers la portion 25-2. Quand ce courant devient suffisant pour que la chute de tension devienne supérieure à environ 0,6 volt, la jonction PN entre le caisson 25 et la région 26 devient passante, d'où il résulte une injection d'électrons dans le substrat 1. Alors, dans le quadrant Q1, c'est-à-dire quand la borne inférieure A1 est positive par rapport à la borne supérieure A2, il se produit un amorçage d'un thyristor pilote constitué des régions et couches 3-1-25-26 ; cet amorçage entraîne la présence d'une grande densité de porteurs dans le substrat 1, ce qui provoque le déclenchement du thyristor de puissance Th1. Dans le quadrant Q4, c'est-à-dire quand la borne inférieure A1 est négative par rapport à la borne supérieure A2, l'émission d'électrons dans le substrat provoque l'amorçage d'un thyristor pilote constitué des régions et couches 25-1-3-9 puis l'amorçage du thyristor de puissance Th2.

Un avantage de la présente invention résulte du fait qu'il n'existe plus dans la structure d'amorçage de résistance intégrée équivalent à la résistance R_{GK} décrite en relation avec les figures 2 et 3. On peut alors désensibiliser vis-à-vis des déclenchements en dV/dt les thyristors Th1, Th2, par exemple en prévoyant des trous de court-circuit d'émetteur dans les régions de type N 6 et 9, sans que cela influe sur les caractéristiques de déclenchement du triac.

La présente invention permet d'obtenir une augmentation nette de la sensibilité de déclenchement dans les quadrants Q1, Q4. Des premières simulations, non affinées, ont montré que, toutes choses égales d'ailleurs, dans le quadrant Q1, on obtient avec l'invention un amorçage pour un courant de gâchette Igt de 3,9 mA alors que avec une structure classique équivalente on devait prévoir un courant de l'ordre de 6,1 mA. De même dans le quadrant Q4, on peut utiliser un courant de déclenchement Igt de 23,1 mA au lieu d'un courant Igt de 27 mA avec une structure selon l'art antérieur. Cette différence est d'autant plus notable que, dans le cas d'une structure selon l'invention, on obtient une insensibilité sensiblement deux fois plus forte à un déclenchement parasite en dV/dt. De plus on peut s'attendre à des résultats encore meilleurs en optimisant les structures. Des premières simulations montrent que l'on devrait obtenir une amélioration supérieure à 50%.

Bien entendu, la présente invention est susceptible de diverses variantes et modifications qui apparaîtront à l'homme de l'art. En particulier, diverses modifications généralement prévues dans les triacs classiques pourront s'adapter sans difficulté à un triac selon la présente invention.

D'autre part, les topographies des diverses couches pourront être modifiées. Notamment, la forme rectangulaire de la zone de déclenchement représentée en figure 5 ne constitue qu'un exemple de réalisation de la présente invention. L'important est que le caisson P auxiliaire destiné au déclenchement comporte une région N qui, en vue de dessus, le sépare sensiblement en deux portions de sorte que le courant de l'une à l'autre des deux portions doit passer dans le caisson sous la région N et soit susceptible de rendre passante la jonction PN entre la région N et le caisson P.

Un avantage de la structure selon la présente invention est que, les caissons P principal 5 et auxiliaire 25 étant tout deux au même potentiel, ils pourront être disposés très près l'un de l'autre sans qu'il soit nécessaire de prévoir une grande distance de substrat N entre eux. En effet, du fait qu'ils sont au même potentiel, il se produit un phénomène d'auto-blindage et les lignes de champ ne sont pas susceptibles, si ces caissons sont suffisamment proches, de pénétrer dans la région intercalaire entre les deux caissons. Ainsi, la structure selon la présente invention n'entraîne pas d'augmentation significative de la surface dédiée à la région de gâchette du composant. Elle ne nécessite pas non plus d'étape particulière de fabrication pour réaliser la zone de gâchette et/ou pour l'isoler d'autres éléments du composant.

## Revendications

1. Triac vertical comprenant du côté de sa face avant, un caisson autonome (25) d'amorçage du deuxième type de conductivité contenant une deuxième région du premier type de conductivité (26) disposée de façon à partager, en vue de dessus, le caisson autonome en une première (25-1) et une deuxième (25-2) portion de caisson, la première portion étant reliée à une borne de commande (G) du triac et la deuxième portion étant reliée avec ladite région (26) à ladite borne principale (A2) de face avant.

2. Triac selon la revendication 1, dans lequel le caisson auxiliaire (25) est disposé au voisinage immédiat du caisson principal (5) de face avant.

## Claims

1. A triac comprising on its front surface an autonomous starting well (25) of the second conductivity type containing a region of the first conductivity type (26) arranged to divide the autonomous well, in top view, into a first (25-1) and a second (25-2) well portion, the first portion being connected to a control terminal (G) of the triac and the second portion being connected with said region (26) to the main front surface terminal (A2).

2. The triac of claim 1, wherein the auxiliary well (25) is arranged in the immediate vicinity of the main front surface well (5).

## Patentansprüche

1. Triac, der an seiner Vorderseite einen autonomen Startbereich bzw. Start-Well (25) mit einer zweiten Leitfähigkeit aufweist, der einen Bereich (26) mit erster Leitfähigkeit enthält, der angeordnet ist, um den autonomen Well in der Draufsicht in einen ersten Well-Teil (25-1) und in einen zweiten Well-Teil (25-2) aufzuteilen, wobei der erste Teil mit einem Steueranschluss (G) des Triac verbunden ist, und wobei der zweite Teil mit dem Bereich (26) mit der Hauptanschluss (A2) der Vorderseite verbunden ist.

2. Triac nach Anspruch 1, wobei der Hilfs-Well (25) in direkter Nachbarschaft zum Haupt-Well (5) der Vorderseite angeordnet ist.
